# EUROPÄISCHE PATENTSCHRIFT

(11) **EP 2 422 357 B1**
(45) Veröffentlichungstag und Bekanntmachung des Hinweises auf die Patenterteilung: **01.07.2020**
(21) Anmeldenummer: 10712355.6
(22) Anmeldetag: 31.03.2010
(51) Int. Cl.: H01L 21/67

(54) **VORRICHTUNG UND VERFAHREN ZUM TRENNEN EINES SUBSTRATS VON EINEM TRÄGERSUBSTRAT**
DEVICE AND METHOD FOR SEPARATING A SUBSTRATE FROM A CARRIER SUBSTRATE
PROCÉDÉ ET DISPOSITIF UTILISÉS POUR SÉPARER UN SUBSTRAT D'UN SUBSTRAT SUPPORT

(30) Priorität: 21.04.2009 DE 102009018156
(43) Veröffentlichungstag der Anmeldung: 29.02.2012
(73) Patentinhaber: EV Group GmbH, 4782 St. Florian am Inn (AT)
(72) Erfinder: WIMPLINGER, Markus, AT-4910 Ried im Innkreis (AT); LINDNER, Paul, AT-4780 Schärding (AT)
(74) Vertreter: Schneider, Sascha
(86) Internationale Anmeldenummer: PCT/EP2010/002054
(87) Internationale Veröffentlichungsnummer: WO 2010/121703

(56) Entgegenhaltungen:
- EP-A2- 0 510 706
- WO-A2-2008/088560
- JP-A- 7 169 723
- JP-A- 2004 063 645
- JP-A- 2008 192 982

## Beschreibung

Die Erfindung betrifft eine Vorrichtung gemäß Anspruch 1 und ein Verfahren gemäß Anspruch 6 zum Trennen eines Substrats von einem mit dem Substrat durch eine Verbindungsschicht verbundenen Trägersubstrat.

Bei Substraten der Halbleiterindustrie handelt es sich häufig um gedünnte, zerbrechliche oder einer Vorspannung unterliegende, beispielsweise gewölbte scheibenförmige, runde oder rechteckige Körper mit sehr geringer Dicke von meist kleiner 300 µm.

In Abhängigkeit von den verwendeten Trägermaterialien und der verwendeten Verbindungsschicht zwischen Träger und Wafer sind verschiedene Verfahren zur Auflösung oder Zerstörung der Verbindungsschicht bekannt, wie beispielsweise die Verwendung von UV-Licht, Laserstrahlen, Temperatureinwirkung oder Lösungsmittel.

Das Abtrennen stellt sich zunehmend als einer der kritischsten Prozessschritte dar, da die dünnen Substrate mit Substratdicken von wenigen µm beim Ablösen/Abziehen leicht brechen oder durch die für den Vorgang des Ablösens notwendigen Kräfte Schaden erleiden.

Darüber hinaus habcn die dünnen Substrate kaum bis keine Formstabilität und rollen sich typischerweise ohne Stützmaterial ein. Während der Handhabung der rückgedünnten Wafer ist mithin eine Fixierung und Unterstützung der Wafer praktisch unumgänglich.

Bei bisher bekannten Verfahren und Vorrichtungen erfolgt das Abtrennen des Substrats vom Trägersubstrat entweder durch Abheben oder durch Abrollen mit dem Nachteil, dass meist erhebliche Kräfte auf das empfindliche Substrat einwirken.

Es ist daher die Aufgabe der vorliegenden Erfindung, eine Vorrichtung und ein Verfahren anzugeben, um ein Subtrat auf möglichst einfache Art und Weise und nach Möglichkeit zerstörungsfrei von einem Träger zu lösen.

Die EP 0 510 706 A2 offenbart eine Vorrichtung zum Ablösen eines Substrats durch Parallelverschiebung des Substrats.

Diese Aufgabe wird mit den Merkmalen der Ansprüche 1 und 6 gelöst.

Vorteilhafte Weiterbildungen der Erfindung sind in den Unteransprüchen angegeben.

Der Erfindung liegt der Gedanke zugrunde, eine Vorrichtung beziehungsweise ein Verfahren zum Trennen eines Substrats von einem mit dem Substrat durch eine Verbindungsschicht verbundenen Trägersubstrat anzugeben, bei welchen die Trennung des Substrats durch Parallelverschiebung von Substrat und Trägersubstrat gegeneinander erfolgt. Von Vorteil ist es dabei, wenn während des überwiegenden Trennvorgangs quasi ausschließlich Kräfte parallel zu einer Substrataufnahmefläche einer das Substrat aufnehmenden Substrataufnahme wirken. Weiterhin ist es von Vorteil, wenn die Abtrennung des Trägersubstrats vom Substrat erfolgt, während das Trägersubstrat von einer Trägersubstrataufnahme zur Aufnahme des Trägersubstrats beabstandet ist beziehungsweise von dieser abgehoben ist. In diesem Fall wirkt in Querrichtung zur Parallelverschiebung des Trägersubstrats zum Substrat idealerweise nur noch die Schwerkraft auf das Trägersubstrat. Insbesondere wirken keine Druckkräfte vom Trägersubstrat in Richtung des Substrats.

Durch die erfindungsgemäße Ausgestaltung wird ein Verkanten des Substrats mit dem Trägersubstrat praktisch ausgeschlossen, insbesondere wenn die Abtrennung durch Krafteinwirkung auf den Umfang des Trägersubstrats erfolgt.

In einer vorteilhaften Ausgestaltung der erfindungsgemäßen Vorrichtung ist vorgesehen, dass Mittel zur Verringerung einer durch die Verbindungsschicht bewirkten Verbindungskraft vorgesehen sind. Als Verbindungsschicht kann ein Kleber vorgesehen sein, der als Thermoplast oder Wachs in einer Dicke von 0,01 µm bis 500 µm zwischen dem Substrat und dem Trägersubstrat vorgesehen sein kann. Der Kleber wird durch Erhitzen oder UV-Bestrahlung oder ein anderes bekanntes Verfahren zumindest teilweise verflüssigt, um die durch den Kleber der Trennung von Substrat und Trägersubstrat entgegenwirkende Haftkraft auf ein Minimum zu reduzieren. Die Verringerung der Verbindungskraft erfolgt mit Vorteil vor der Trennung des Substrats vom Trägersubstrat.

Erfindungsgemäß umfassen die Trennungsmittel einen, durch einen Linearantrieb antreibbaren, Führungsschlitten zur Parallelverschiebung des Substrats gegenüber dem Trägersubstrat. Die Parallelverschiebung als Relativbewegung kann durch Bewegung des Substrats bei fixiertem Trägersubstrat oder durch Bewegung des Trägersubstrats bei fixiertem Substrat oder durch Bewegung des Trägersubstrats und des Substrats erfolgen. Besonderes vorteilhaft ist eine Ausgestaltung, bei der das Substrat an der Substrataufnahmefläche der Substrataufnahme fixiert bleibt und gegenüber dem seitlich fixierten Trägersubstrat parallel verschoben wird. Auf diese Weise kann das Substrat nämlich während des Trennvorgangs durch die Substrataufnahmefläche vor einem Zerbrechen geschützt werden.

In einer weiteren vorteilhaften Ausgestaltung der Erfindung ist vorgesehen, dass die Trennungsmittel Anhebemittel zur Anhebung des mit dem Trägersubstrat verbundenen Substrats umfassen, insbesondere durch Anhebung des Führungsschlittens. Durch Anhebung des aus dem Trägersubstrat, der Verbindungsschicht und dem Substrat bestehenden Substrat-Trägersubstrat-Verbundes kann das Trennen des Substrats vom Trägersubstrat bei schwebendem Trägersubstrat erfolgen, so dass abgesehen von der auf das Trägersubstrat selbst wirkenden Schwerkraft keine sonstigen, quer zur Parallelverschiebung wirkenden Kräfte auf das Trägersubstrat einwirken.

Indem die Trägersubstrataufnahme Trägersubstratfixiermittel zur Fixierung des Trägersubstrats auf der Aufnahmefläche umfasst und/oder die Substrataufnahme Substratfixiermittel zur Fixierung des Substrats auf der Substrataufnahmefläche umfasst, sind sowohl das Substrat als auch das Trägersubstrat auf einfachste Art und Weise direkt mit der Trägersubstrataufnahme beziehungsweise Substrataufnahme fixierbar. Mit Vorteil erfolgt die Fixierung durch Anlegen eines Unterdrucks beziehungsweise Vakuums an einem Teil der Kontaktfläche des Substrats beziehungsweise Trägersubstrats mit der Substrataufnahme beziehungsweise der Trägersubstrataufnahme.

Da erfindungsgemäß die Trennungsmittel, insbesondere ausschließlich, entgegen der Parallelverschiebung wirkende Haltemittel, nämlich an der Trägersubstrataufnahme angebrachte, Anschläge umfassen, ist auf einfachste Art und Weise eine der Parallelverschiebung zum Trennen des Substrats vom Trägersubstrat entgegenwirkende Kraft an dem Trägersubstrat oder dem Substrat anlegbar. Die Kraft wirkt auf diese Weise ausschließlich auf die Seite beziehungsweise den Umfang des Trägersubstrats ein, so dass keine Querkräfte durch die Haltemittel erzeugt werden.

Erfindungsgemäß ist vorgesehen, dass dem Linearantrieb eine Antriebsregelung zugeordnet ist, mit der die Geschwindigkeit der Parallelverschiebung durch den Führungsschlitten 8 regelbar ist. Erfindungsgemäß wird dabei zur Regelung der Geschwindigkeit die Ablösekraft mit Kraftmessmitteln gemessen, da die Ablösekraft unter anderem von der Kontaktfläche zwischen Substrat und Trägersubstrat abhängt, die sich während des Ablösevorgangs ändert. Zur Kraftmessung können als Kraftmessmittel Kraftmesszellen vorgesehen sein oder eine Messung der Stromaufnahme des Linearantriebs erfolgen. Weniger aufwendig ist eine nach bestimmten Vorgaben steigende Geschwindigkeit vom Beginn des Ablösens bis zum Ende des Ablösevorgangs ohne Einfluss von Kraftmessmitteln.

Mit Vorteil erfolgt die Ablösung bei konstanter Ablösekraft. Die Geschwindigkeit der Parallelverschiebung ist demnach indirekt proportional zur wirksamen Kontaktfläche zwischen Substrat und Trägersubstrat.

Das erfindungsgemäße Verfahren zum Trennen eines Substrats von einem mit dem Substrat durch eine Verbindungsschicht verbundenen Trägersubstrat weist in seiner allgemeinsten Form folgende Schritte auf:
- Aufnahme eines aus dem Trägersubstrat, der Verbindungsschicht und dem Substrat bestehenden Substrat-Trägersubstrat-Verbundes zwischen einer Substrataufnahmefläche einer Substrataufnahme und einer parallel zur Substrataufnahmefläche anordenbaren Aufnahmefläche einer Trägersubstrataufnahme,
- Trennung des Substrats von dem Trägersubstrat durch Parallelverschiebung des Substrats gegenüber dem Trägersubstrat in einem verbundenen Zustand von Substrat und Trägersubstrat .

In einer vorteilhaften Ausgestaltung der Erfindung wird eine durch die Verbindungsschicht bewirkte Verbindungskraft nach der Aufnahme und vor der Trennung verringert. Dadurch wird die für die Trennung erforderliche Kraft kleiner und es werden Beschädigungen am Substrat beziehungsweise Trägersubstrat vermieden.

In dem erfindungsgemäßen Verfahren erfolgt die Trennung durch einen, durch einen Linearantrieb antreibbaren, Führungsschlitten zur Parallelverschiebung des Substrats gegenüber dem Trägersubstrat. An einem Führungsschlitten kann eine besonders exakte Parallelverschiebung verwirklicht werden.

Gemäß einer weiteren, vorteilhaften Ausgestaltung der Erfindung ist vorgesehen, dass vor der Trennung eine Anhebung des Substrat-Trägersubstrat-Verbundes erfolgt, nachdem gegebenenfalls eine Fixierung des Trägersubstrats an der Trägersubstrataufnahme aufgehoben worden ist. Das Trägersubstrat kann dann frei schwebend von dem Substrat getrennt werden.

Erfindungsgemäß ist vorgesehen, dass die Trennung des Substrats von dem Trägersubstrat zumindest überwiegend ausschließlich durch Parallelverschiebung erfolgt. Zu Beginn des durch Parallelverschiebung ablaufenden Trennvorganges ist die Kontaktfläche zwischen dem Substrat und dem Trägersubstrat am größten, so dass zu Beginn des Trennvorganges die für die Trennung erforderliche Trennkraft am größten ist und diese nimmt bis zur vollständigen Trennung des Substrats vom Trägersubstrat kontinuierlich ab. Insofern kann nach zumindest überwiegender Trennung des Substrats von dem Trägersubstrat auch eine zusätzliche Kraftkomponente quer zur Parallelverschiebung eingebracht werden. Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in:
- Fig. 1:: eine schematische Seitenansicht der erfindungsgemäßen Vorrichtung in einem ersten Verfahrensschritt,
- Fig. 2:: eine schematische Seitenansicht der erfindungsgemäßen Vorrichtung in einem zweiten Verfahrensschritt,
- Fig. 3:: eine schematische Seitenansicht der erfindungsgemäßen Vorrichtung in einem dritten Verfahrensschritt und
- Fig. 4:: eine schematische Seitenansicht der erfindungsgemäßen Vorrichtung in einem vierten Verfahrensschritt,

In den Figuren sind gleiche Bauteile und Bauteile mit der gleichen Funktion mit den gleichen Bezugszeichen gekennzeichnet.

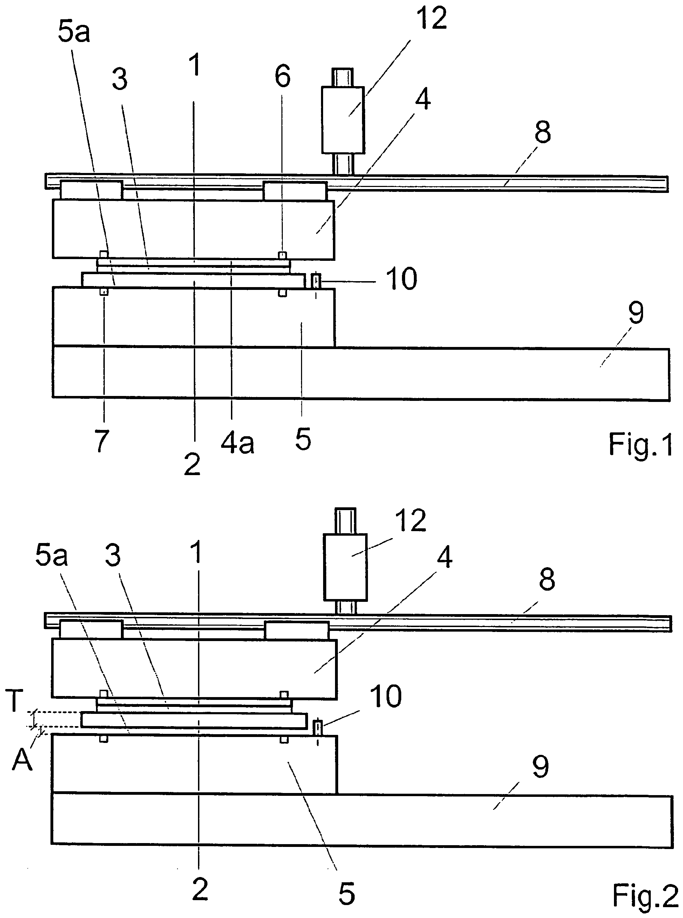

Die in den Figuren 1 bis 4 dargestellte Vorrichtung besteht aus einer stabilen und möglichst vibrationsarmen Grundplatte 9. Oberhalb der Grundplatte 9 sind die übrigen Bauteile der Vorrichtung angeordnet und insbesondere mit der Grundplatte 9 mechanisch verbunden, was in der schematischen Darstellung nicht gezeigt ist.

Auf der Grundplatte 9 liegt eine Trägersubstrataufnahme 5 auf, die als Chuck ausgebildet ist und mit ihrer von der Grundplatte 9 abgewandten Seite als Aufnahmefläche 5a zur Aufnahme eines Trägersubstrats 2 dient.

Das Trägersubstrat 2 ist durch Trägersubstratfixiermittel 7, die in der Ausführungsform als Vakuumrillen ausgebildet sind, an der Aufnahmefläche 5a und damit an der Trägersubstrataufnahme 5 fixierbar.

Die Fixierung kann durch entsprechende Steuerungsmittel gesteuert werden.

Seitlich neben der für die Aufnahme des Trägersubstrats 2 vorgesehenen Aufnahmefläche 5a sind Haltemittel 10 an der Trägersubstrataufnahme 5 vorgesehen, die steckbar ausgebildet sein können. Damit ist ein Austausch der Haltemittel 10 für verschieden dicke Trägersubstrate 2 möglich und die Haltemittel sind an die Größe des Trägersubstrats 2 anpassbar. Durch Vorsehen mehrerer Steckpositionen am Umfang des Trägersubstrats 2 sind auch verschiedene Formen und Größen des Trägersubstrats realisierbar.

Gegenüberliegend zu der Grundplatte 9 beziehungsweise zu der Trägeraufnahme 5 ist ein Führungsschlitten 8 mit nicht dargestelltem Linearantrieb parallel zu der Aufnahmefläche 5a angeordnet. An dem Führungsschlitten 8 ist eine Substrataufnahme 4 mit einer Substrataufnahmefläche 4a zur Aufnahme eines Substrats 1 parallelverschieblich zur Aufnahmefläche 5a angebracht.

Das Substrat 1 ist durch Substratfixiermittel 6, hier Vakuumrillen, in bekannter Weise an der Substrataufnahme 4 im Beriech der Substrataufnahmefläche 4a fixierbar.

Die Fixierung durch die Substratfixiermittel 6 beziehungsweise die Trägersubstratfixiermittel 7 kann alternativ durch elektrostatische Fixierung oder durch mechanische Klemmung erfolgen.

Durch einen orthogonal zum Führungsschlitten 8 angeordneten Z-Führungsschlitten 12 mit Linearantrieb ist der Führungsschlitten 8 und damit die Substrataufnahme 4 orthogonal zur Aufnahmefläche 5a beziehungsweise zur Substrataufnahmefläche 4a bewegbar. Der Z-Führungsschlitten 12 dient als Anhebemittel zur Anhebung des mit dem Trägersubstrat 2 verbundenen Substrats 1.

Das Substrat 1 ist mit dem Trägersubstrat 2 durch eine Verbindungsschicht 3, beispielsweise einem thermoplastischen Kleber, verbunden. Die Anordnung des Substrats 1 und des Trägersubstrats 2 und damit der Substrataufnahme 4 und der Trägersubstrataufnahme 5 kann auch umgekehrt, das heißt um 180° gedreht sein.

In dem in Figur 1 dargestellten Verfahrensschritt ist die Aufnahme des aus dem Substrat 1, der Verbindungsschicht 3 und dem Trägersubstrat 2 bestehenden Substrat-Trägersubstrat-Verbundes durch die Substrataufnahme 4 und die Trägersubstrataufnahme 5 dargestellt. Von besonderer Bedeutung ist dabei eine absolut parallele Ausrichtung der Substrataufnahme 4 beziehungsweise der Substrataufnahmefläche 4a gegenüber der Trägersubstrataufnahme 5 beziehungsweise der Aufnahmefläche 5a.

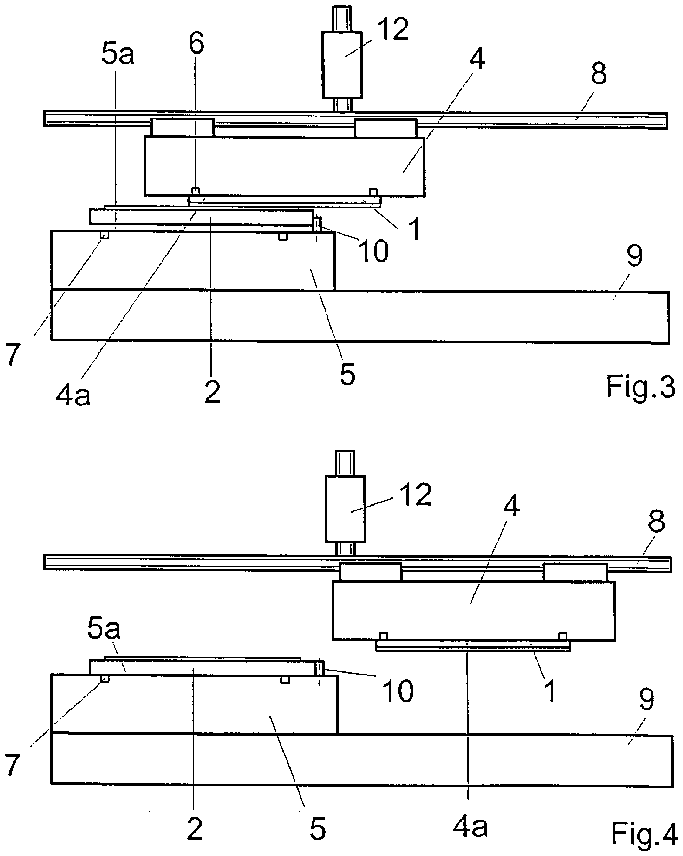

Anschließend wird der Substrat-Trägersubstrat-Verbund gemäß Figur 2 durch den Führungsschlitten 12 geringfügig angehoben, und zwar exakt orthogonal zu der Aufnahmefläche 5a, damit bei der sich anschließenden Parallelverschiebung gemäß Figuren 3 und 4 zwischen der Aufnahmefläche 5a und dem Trägersubstrat 2 kein Kontakt besteht. Das Trägersubstrat 2 wird mit Vorteil um eine Anhebehöhe A von weniger als der Trägersubstrathöhe T angehoben.

Im Anschluss an das Anheben gemäß Figur 2 beziehungsweise während des Anhebens gemäß Figur 2 wird die durch die Verbindungsschicht 3 bewirkte Verbindungskraft zwischen Substrat 1 und Trägersubstrat 2 durch Mittel zur Verringerung der Verbindungskraft verringert, beispielsweise durch Temperatureintrag.

In dem Verfahrensschritt gemäß Figur 3 findet eine Parallelverschiebung des Substrats 1 entlang des Führungsschlittens 8 statt, die durch den Linearmotor (nicht dargestellt) bewirkt wird. Bis das Trägersubstrat 2 an dem als Pins ausgebildeten Haltemitteln 10 anschlägt, findet noch keine Relativbewegung zwischen dem Substrat 1 und dem Trägersubstrat 2 statt. Sobald das Trägersubstrat 2 an dem Pin beziehungsweise den Pins anschlägt, beginnt das Trennen des Substrats 1 von dem Trägersubstrat 2 durch Parallelverschiebung des Substrats 1 gegenüber dem Trägersubstrat 2. Bei der Parallelverschiebung wirken - abgesehen von der auf das Trägersubstrat 2 wirkenden Schwerkraft durch das Gewicht des Trägersubstrats 2 keine Querkräfte, so dass eine Beschädigung des empfindlichen Substrats 1, das darüber hinaus noch durch die Substrataufnahme 4 geschützt ist, quasi ausgeschlossen ist.

In Figur 4 ist der Trennvorgang abschlossen, wobei der Trennvorgang nicht ausschließlich aus einer Parallelverschiebung bestehen muss, sondern nur überwiegend, da die durch die Verbindungsschicht 3 bewirkte Haftkraft zwischen dem Substrat 1 und dem Trägersubstrat 2 während des Trennvorgangs ständig abnimmt und gegen Ende des Trennvorgangs zusätzlich zu der Parallelverschiebung eine Verschiebung in orthogonaler Richtung vorgenommen werden kann. Soweit das Trägersubstrat 2 aber nach dem Trennvorgang in der Position gemäß Figur 4 abgelegt sein soll, ist es vorteilhaft, den Trennvorgang vollständig durch Parallelverschiebung zu bewirken. Alternativ kann das Trägersubstrat 2 gegen Ende des Trennvorganges durch die als Vakuumrillen ausgestalteten Fixiermittel 7 von dem Substrat 1 abgezogen werden.

### Bezugszeichenliste

- 1: Substrat
- 2: Trägersubstrat
- 3: Verbindungsschicht
- 4: Substrataufnahme
- 4a: Substrataufnahmefläche
- 5: Trägersubstrataufnahme
- 5a: Aufnahmefläche
- 6: Substratfixiermittel
- 7: Trägersubstratfixiermittel
- 8: Führungsschlitten
- 9: Grundplatte
- 10: Haltemittel
- 12: Z-Führungsschlitten

## Patentansprüche

1. Vorrichtung zum Trennen eines Substrats (1) von einem mit dem Substrat (1) durch eine Verbindungsschicht (3) verbundenen Trägersubstrat (2) mit
- einer Trägersubstrataufnahme (5) mit einer Aufnahmefläche (5a) zur Aufnahme des Trägersubstrats (2),
- einer gegenüberliegend zur Trägersubstrataufnahme (5) angeordneten Substrataufnahme (4),
- Trennungsmitteln zur Parallelverschiebung des Substrats (1) gegenüber dem Trägersubstrat (2) in einem verbundenen Zustand von Substrat (1) und Trägersubstrat (2), wobei die Trennungsmittel einen durch einen Linearantrieb antreibbaren Führungsschlitten (8) zur Parallelverschiebung des Substrats (1) gegenüber dem Trägersubstrat (2) umfassen, und wobei dem Linearantrieb eine Antriebsregelung zugeordnet ist, mit der die Geschwindigkeit mit der Parallelverschiebung durch den Führungsschlitten (8) mit Kraftmessmitteln zur Messung der Ablösekraft während des Ablösens regelbar ist,
**dadurch gekennzeichnet, dass** die Substrataufnahme (4) eine parallel zur Aufnahmefläche (5a) anordenbare Substrataufnahmefläche (4a) zur Aufnahme des Substrats (1) aufweist und dass die Trennungsmittel entgegen der Parallelverschiebung wirkende Haltemittel (10), nämlich an der Trägersubstrataufnahme (5) angebrachte Anschläge, umfassen.

2. Vorrichtung nach Anspruch 1,
**dadurch gekennzeichnet, dass** Mittel zur Verringerung einer durch die Verbindungsschicht (3) bewirkten Verbindungskraft vorgesehen sind.

3. Vorrichtung nach mindestens einem der vorhergehenden Ansprüche,
**dadurch gekennzeichnet, dass** die Trennungsmittel Anhebemittel zur Anhebung des mit dem Trägersubstrat (2) verbundenen Substrats (1) umfassen, insbesondere durch Anhebung des Führungsschlittens (8).

4. Vorrichtung nach mindestens einem der vorhergehenden Ansprüche,
**dadurch gekennzeichnet, dass** die Trägersubstrataufnahme (5) Trägersubstratfixiermittel (7) zur Fixierung des Trägersubstrats (2) auf der Aufnahmefläche (5a) umfasst.

5. Vorrichtung nach mindestens einem der vorhergehenden Ansprüche,
**dadurch gekennzeichnet, dass** die Substrataufnahme (4) Substratfixiermittel (6) zur Fixierung des Substrats (1) auf der Substrataufnahmefläche (4a) umfasst.

6. Verfahren zum Trennen eines Substrats von einem mit dem Substrat durch eine Verbindungsschicht verbundenen Trägersubstrat mit folgenden Schritten:
- Aufnahme eines aus dem Trägersubstrat, der Verbindungsschicht und dem Substrat bestehenden Substrat-Trägersubstrat-Verbundes,
- Trennung des Substrats von dem Trägersubstrat durch Parallelverschiebung des Substrats gegenüber dem Trägersubstrat in einem verbundenen Zustand von Substrat und Trägersubstrat, wobei die Trennung mittels eines durch einen Linearantrieb antreibbaren Führungsschlitten zur Parallelverschiebung des Substrats gegenüber dem Trägersubstrat erfolgt, wobei dem Linearantrieb eine Antriebsregelung zugeordnet ist, mit der die Geschwindigkeit mit der Parallelverschiebung durch den Führungsschlitten (8) mit Kraftmessmitteln zur Messung der Ablösekraft während des Ablösens geregelt wird,
**dadurch gekennzeichnet, dass** die Aufnahme des Substrat-Trägersubstrat-Verbundes zwischen einer Substrataufnahmefläche einer Substrataufnahme und einer parallel zur Substrataufnahmefläche anordenbaren Aufnahmefläche einer Trägersubstrataufnahme erfolgt und dass die Trennung durch an der Trägersubstrataufnahme (5) angebrachte Anschläge entgegen der Parallelverschiebung bewirkt wird.

7. Verfahren nach Anspruch 6,
**dadurch gekennzeichnet,**
**dass** eine durch die Verbindungsschicht bewirkte Verbindungskraft nach der Aufnahme und vor der Trennung verringert wird.

8. Verfahren nach Anspruch 6 oder 7 mit einer Vorrichtung nach einem der Ansprüche 1 bis 5.

9. Verfahren nach mindestens einem der Ansprüche 6 bis 8,
**dadurch gekennzeichnet,**
**dass** vor der Trennung eine Anhebung des Substrat-Trägersubstrat-Verbundes erfolgt, insbesondere nach einer Aufhebung der Fixierung des Trägersubstrats an der Trägersubstrataufnahme.

10. Verfahren nach mindestens einem der Ansprüche 6 bis 9,
**dadurch gekennzeichnet,**
**dass** die Trennung des Substrats von dem Trägersubstrat zumindest überwiegend ausschließlich durch Parallelverschiebung erfolgt.

## Claims

1. A device for separating a substrate (1) from a carrier substrate (2) bonded to the substrate (1) by a bonding layer (3), comprising
- a carrier substrate mount (5) with a mounting surface (5a) for mounting the carrier substrate (2),
- a substrate mount (4) arranged opposite the carrier substrate mount (5),
- separating means for the parallel displacement of the substrate (1) with respect to the carrier substrate (2) in a bonded state of the substrate (1) and the carrier substrate (2), wherein the separating means comprise a guide carriage (8) drivable by means of a linear drive for the parallel displacement of the substrate (1) with respect to the carrier substrate (2), and wherein a drive control is assigned to the linear drive, with which the speed with the parallel displacement by means of the guide carriage (8) can be regulated with force measuring means for measuring the detachment force during the detachment,
**characterised in that** the substrate mount (4) comprises a substrate mounting surface (4a), which can be arranged parallel to the mounting surface (5a), for mounting the substrate (1) and that the separating means comprise retaining means (10), i.e. stops fitted on the carrier substrate mount (5), said retaining means (10) acting against the parallel displacement.

2. The device according to claim 1,
**characterised in that** means are provided for reducing a bonding force brought about by the bonding layer (3).

3. The device according to at least one of the preceding claims,
**characterised in that** the separating means comprise lifting means for lifting the substrate (1) bonded to the carrier substrate (2), in particular by lifting the guide carriage (8).

4. The device according to at least one of the preceding claims,
**characterised in that** the carrier substrate mount (5) comprises carrier substrate fixing means (7) for fixing the carrier substrate (2) on the mounting surface (5a).

5. The device according to at least one of the preceding claims,
**characterised in that** the substrate mount (4) comprises substrate fixing means (6) for fixing the substrate (1) on the substrate mounting surface (4a).

6. A method for separating a substrate from a carrier substrate bonded to the substrate by a bonding layer, with the following steps:
- mounting of a substrate-carrier substrate compound structure comprising the carrier substrate, the bonding layer and the substrate,
- separation of the substrate from the carrier substrate by parallel displacement of the substrate with respect to the carrier substrate in a bonded state of the substrate and the carrier substrate, wherein the separation takes place by means of a guide carriage drivable by means of a linear drive for the parallel displacement of the substrate with respect to the carrier substrate, wherein a drive control is assigned to the linear drive, with which the speed with the parallel displacement by means of the guide carriage (8) is regulated with force measuring means for measuring the detachment force during the detachment,
**characterised in that** the mounting of the substrate-carrier substrate compound structure between a substrate mounting surface of a substrate mount and a mounting surface of a carrier substrate mount which can be arranged parallel to the substrate mounting surface takes place and that the separation is brought about by stops fitted to the carrier substrate mount (5) acting against the parallel displacement.

7. The method according to claim 6,
**characterised in that**
a bonding force brought about by the bonding layer is reduced after the mounting and before the separation.

8. The method according to claim 6 or 7 with a device according to any one of claims 1 to 5.

9. The method according to at least one of claims 6 to 8,
**characterised in that**
lifting of the substrate-carrier substrate compound structure takes place before the separation, in particular after the removal of the fixing of the carrier substrate to the carrier substrate mount.

10. The method according to at least one of claims 6 to 9,
**characterised in that**
the separation of the substrate from the carrier substrate takes place at least for the most part solely by parallel displacement.

## Revendications

1. Dispositif pour séparer un substrat (1) d'un substrat porteur (2) relié au substrat (1) par une couche de liaison (3) comprenant
- une réception de substrat porteur (5) comprenant une surface de réception (5a) pour recevoir le substrat porteur (2),
- une réception de substrat (4) disposée opposée à la réception de substrat porteur (5),
- des moyens de séparation pour le déplacement parallèle du substrat (1) par rapport au substrat porteur (2) dans un état relié du substrat (1) et du substrat porteur (2), dans lequel les moyens de séparation comprennent un chariot de guidage (8) pouvant être entraîné par un entraînement linéaire pour le déplacement parallèle du substrat (1) par rapport au substrat porteur (2), et dans lequel un réglage d'entraînement est attribué à l'entraînement linéaire, avec lequel la vitesse peut être réglée avec le déplacement parallèle par le chariot de guidage (8) avec des moyens de mesure de la force pour mesurer la force de séparation pendant la séparation,
**caractérisé en ce que** la réception de substrat (4) présente une surface de réception de substrat (4a) pouvant être agencée parallèlement à la surface de réception (5a) pour recevoir le substrat (1) et que les moyens de séparation comprennent des moyens de fixation (10) agissant contre le déplacement parallèle, à savoir des butées appliquées sur la réception de substrat porteur (5).

2. Dispositif selon la revendication 1,
**caractérisé en ce que** des moyens pour réduire une force de liaison exercée par la couche de liaison (3) sont prévus.

3. Dispositif selon au moins l'une des revendications précédentes,
**caractérisé en ce que** les moyens de séparation comprennent des moyens de levage pour lever le substrat (1) relié au substrat porteur (2), en particulier en soulevant le chariot de guidage (8).

4. Dispositif selon au moins l'une des revendications précédentes,
**caractérisé en ce que** la réception de substrat porteur (5) comprend des moyens de fixation de substrat porteur (7) pour fixer le substrat porteur (2) sur la surface de réception (5a).

5. Dispositif selon au moins l'une des revendications précédentes,
**caractérisé en ce que** la réception de substrat (4) comprend des moyens de fixation de substrat (6) pour fixer le substrat (1) sur la surface de réception de substrat (4a).

6. Procédé pour séparer un substrat d'un substrat porteur relié au substrat par une couche de liaison, comprenant les étapes suivantes :
- réception d'un composite de substrat porteur-substrat composé du substrat porteur, de la couche de liaison et du substrat,
- séparation du substrat du substrat porteur par déplacement parallèle du substrat par rapport au substrat porteur dans un état relié du substrat et du substrat porteur, dans lequel la séparation est effectuée au moyen d'un chariot de guidage pouvant être entraîné par un entraînement linéaire pour le déplacement parallèle du substrat par rapport au substrat porteur, dans lequel un réglage d'entraînement est attribué à l'entraînement linéaire, avec lequel la vitesse est réglée avec le déplacement parallèle par le chariot de guidage (8) avec des moyens de mesure de la force pour mesurer la force de séparation pendant la séparation,
**caractérisé en ce que** la réception du composite de substrat porteur-substrat a lieu entre une surface de réception de substrat d'une réception de substrat et une surface de réception d'une réception de substrat porteur pouvant être agencée parallèlement à la surface de réception de substrat et que la séparation est effectuée contrairement au déplacement parallèle par des butées appliquées sur la réception de substrat porteur (5).

7. Procédé selon la revendication 6,
**caractérisé en ce qu'**
une force de liaison exercée par la couche de liaison est réduite après la réception et avant la séparation.

8. Procédé selon la revendication 6 ou 7, comprenant un dispositif selon l'une des revendications 1 à 5.

9. Procédé selon au moins l'une des revendications 6 à 8,
**caractérisé en ce qu'**
avant la séparation, un levage du composite de substrat porteur-substrat est effectué, en particulier après une annulation de la fixation du substrat porteur sur la réception de substrat porteur.

10. Procédé selon au moins l'une des revendications 6 à 9,
**caractérisé en ce que**
la séparation du substrat du substrat porteur a lieu au moins principalement exclusivement par déplacement parallèle.
